# EUROPÄISCHE PATENTSCHRIFT

(11) **EP 0 905 779 B1**
(45) Veröffentlichungstag und Bekanntmachung des Hinweises auf die Patenterteilung: **24.07.2013**
(21) Anmeldenummer: 98116971.7
(22) Anmeldetag: 08.09.1998
(51) Int. Cl.: H01L 25/00, H01L 23/528, H01L 25/065, H01L 25/18

(54) **Anordnung mit zwei integrierten Schaltkreisen**
Device with two integrated circuits
Dispositif ayant deux circuits intégrés

(30) Priorität: 30.09.1997 DE 19743264
(43) Veröffentlichungstag der Anmeldung: 31.03.1999
(73) Patentinhaber: Infineon Technologies AG, 85579 Neubiberg (DE)
(72) Erfinder: Mayer, Albrecht, Dr., 82041 München (DE); von Wendorff, Wilhard, Dr., 81241 München (DE)
(74) Vertreter: Jannig, Peter

(56) Entgegenhaltungen:
- EP-A- 0 427 226
- EP-A- 0 780 893
- EP-A- 0 782 191
- WO-A-96/22622
- JP-A- 9 232 513
- US-A- 3 809 625
- US-A- 5 475 236
- US-A- 5 534 465

## Beschreibung

Die Erfindung betrifft eine Anordnung mit zwei integrierten Schaltkreisen.

Bei der Entwicklung von aus integrierten Schaltkreisen bestehenden Anwendungssystemen ist es erforderlich, daß bestimmte Schaltkreise, insbesondere Mikroprozessoren oder Microcontroller, im Anwendungssystem in Echtzeit betrieben werden, wobei eine Vielzahl von im späteren Normalbetrieb nicht zugänglichen elektrischen und zeitlichen Abläufen im Schaltkreis selbst überwacht wird, sogenannte In-Circuit-Emulation (ICE). Das Anwendungssystem kann zusammen mit dem Microcontroller getestet, optimiert und weiterentwickelt werden.

Problematisch ist die Herstellung einer für die In-Circuit-Emulation geeigneten Variante des Serienproduktschaltkreises. Bisher wird hierzu eine Bond-Out-Version hergestellt, bei der zusätzliche interne Signale außen abgreifbar sind. Außerdem wird eine Schaltungsperipherie mit externen Bausteinen geschaffen, durch die beispielsweise Unterbrechungspunkte im Programmablauf gesetzt, Daten- und/oder Programmspeicher verändert und Registerzustände im Zeitablauf aufgenommen werden können. Ein Bedienungsrechner bildet die Schnittstelle zum Entwickler.

Der Aufwand zur Herstellung eines Emulationsschaltkreises ist außerordentlich hoch. Gegenüber der Serienproduktversion steht er meist mit erheblicher Verzögerung zur Verfügung. Außerdem hat der Emulationsschaltkreis gegenüber dem Produktschaltkreis ein zeitlich anderes Betriebsverhalten, was insbesondere auf Störsignale zutrifft und die Fehlersuche erschwert.

In der Literaturstelle M. Yasumoto et. al.: "Promising new Fabrication Process Developed for Stagged LSI's", IEDM 84, Seiten 816 bis 819 ist bereits eine Anordnung aus zwei integrierten Schaltungen gezeigt, die miteinander verbunden sind, indem deren Oberflächen einander gegenüberliegen. Die jeweils oberflächlich zugänglichen Kontaktflächen liegen übereinander und werden über Kontaktsteilen aus Gold miteinander verbunden. Die beiden Schaltungen enthalten jeweils nur Transistoren eines Typs und bilden zusammengefaßt einen Ring-Oszillator. Eine der Schaltungen enthält Außenkontakte.

Eine weitere Anordnung mit zwei integrierten Schaltkreisen ist aus der EP-A-0 780 893 bekannt. Dieser Stand der Technik ähnelt dem vorstehend erwähnten, in IEDM 84 beschriebenen Stand der Technik.

Die Aufgabe der Erfindung besteht darin, eine zur einfachen Herstellung eines Emulationsschaltkreises geeignete Schaltkreisanordnung anzugeben.

Diese Aufgabe wird durch die in Patentanspruch 1 beanspruchte Schaltkreisanordnung gelöst.

Der Aufwand für die gegenüber dem Massenproduktchip zusätzlichen Herstellungsprozeßschritte für die Emulationsvariante sind vertretbar. Der zusätzliche Aufwand im Produktchip, beispielsweise die nur für die Emulationsvariante benötigten Kontaktierungsflächen in der obersten Verdrahtungsebene, erfordern kaum Flächenbedarf. Vorteilhaft ist, daß Produktchip und Emulationsvariante auf dem gleichen Ausgangschip basieren und daher nahezu identisches zeitliches Betriebsverhalten haben.

Zweckmäßigerweise wird zum Abgriff von internen Signalen ein zweiter Schaltkreis vorgesehen, der auf dem durch die zusätzlichen Herstellungsprozeßschritte ergänzten Produktchip mittels einer an die Flip-Chip-Technik angelehnten Methode aufgebracht wird.

Der zusätzliche zweite Chip enthält geeignete Schaltungen für Unterbrechungspunkte, Beobachtungskanalspeicher, ROM-Emulationsspeicher und Signaltreiber. Er kann außerdem für unterschiedliche Produktchips verwendet werden, sofern deren Kontaktflächen in der obersten, zusätzlichen Verdrahtungsebene im gleichen Raster angeordnet sind und die jeweils entsprechenden Signale bereitstellen. Die Emulationsschaltkreisanordnung ist daher kurzzeitig und mit vertretbarem Aufwand verfügbar und verhält sich nahezu identisch zum Produktchip. Durch die enge räumliche Kopplung mit einem ROM-Emulationsspeicher kann maximale Systemfrequenz erreicht werden.

Nachfolgend wird die Erfindung anhand der in der Zeichnung dargestellten Figuren näher erläutert. Es zeigen:
- Figur 1: einen Querschnitt durch die mit den zusätzlichen Herstellungsprozeßschritten ergänzte Emulationschipvariante des Serienproduktchips;
- Figur 2: einen Querschnitt durch eine Emulationsschaltkreisanordnung mit der Emulationsvariante des Serienproduktchips und dem Ausgabechip für zusätzliche Logik und Ausgangstreiber;
- Figur 3: eine Detailaufsicht auf die oberste Verdrahtungsebene des Emulationschips;
- Figur 4: eine Gesamtaufsicht auf die oberste Verdrahtungsebene;
- Figur 5: eine Gesamtansicht der Emulationsschaltkreisanordnung mit Emulationschip, Ausgabechip und Gehäuse;
- Figur 6: ESD-Schutzstrukturen für den Emulationschip und
- Figur 7: ein Blockschaltbild des Ausgabechips.

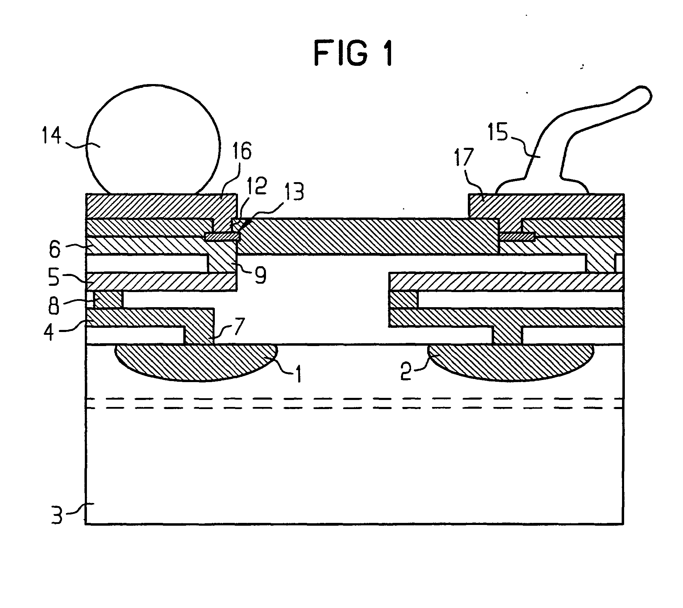

Der in Figur 1 dargestellte Querschnitt zeigt Dotierungsgebiete 1, 2 in einem Halbleitersubstrat. Die Dotierungsgebiete sind untereinander über Leiterbahnen in Verbindungsschichten 4, 5, 6 miteinander verbunden. Die Verbindungsschichten können Leiterbahnen aus Metall, Polysilizium oder anderen elektrisch leitfähigen Materialien enthalten. Verschiedene Leiterebenen sind durch passive Schichten, die beispielsweise mit Siliziumoxiden gebildet sind, gegeneinander isoliert.

Leiterbahnen verschiedener Schichten werden über Kontakte 7, 8, 9, die innerhalb von in den Isolierungsschichten angeordneten Durchgangslöchern angebracht sind, elektrisch miteinander verbunden. Der für die Massenherstellung vorgesehene Produktchip weist in der dargestellten Ausführungsform drei Verbindungsebenen 4, 5, 6 auf, von denen die oberste Verbindungsebene 6 mit einer Schutz- und Passivierungsschicht bedeckt ist (nicht dargestellt).

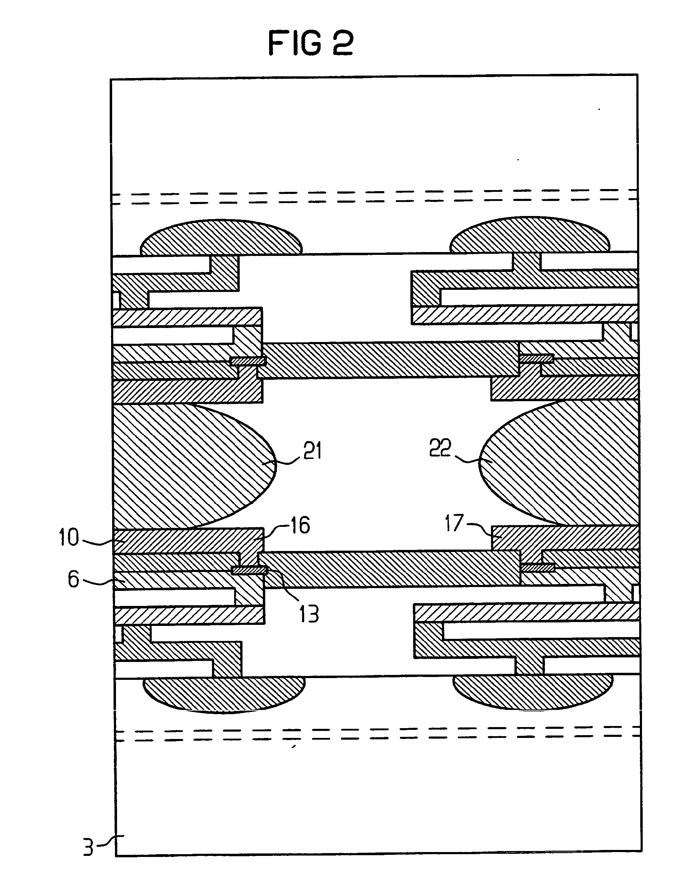

Die in Figur 1 dargestellte Emulationsvariante unterscheidet sich vom Serienproduktchip dadurch, daß über der obersten Verbindungsschicht 6 eine weitere Verbindungsschicht 10, getrennt durch eine weitere Isolationsschicht 11, angeordnet ist. Ein Kontakt 12 verbindet die Leiterbahnen der Ebene 10 mit den Leiterbahnen der Ebene 6. Wie herkömmlich ist der Chip an seiner Oberseite mit einer Passivierung (nicht dargestellt) abgeschlossen. Für die vertikalen Kontakte 12 weist die oberste Verdrahtungsschicht 6 des Produktchips entsprechende Kontaktflächen 13 auf. Diese Kontaktflächen sind im Produktchip mangels der Verdrahtungsebene 10 unbenutzt und für dessen eigentliche Funktion nicht erforderlich. Der zusätzliche Flächenaufwand für die Kontaktflächen ist minimal. Durch die zusätzliche Verdrahtungsschicht 10 sowie die Kontakte 12 werden solche Signale an die Chipoberfläche geführt, die im Produktchip gerade nicht nach außen geführt werden. In der dargestellten Emulationsvariante sind sie jedoch über Kontaktierungen 14, 15 außen abgreifbar. Die derart abgreifbaren Signalleitungen sind beispielsweise chipinterne Daten- und Singalbusse. Auf der links dargestellten Leiterbahn 16 der obersten Verdrahtungsebene 10 des Emulationschips ist eine Kontaktwarze 14 aufgebracht, durch die das Signal der Leiterbahn 16 in einem Ausgabechip weiterverarbeitet wird (vgl. Figur 2). Als alternative Kontaktmethode ist bei der rechts dargestellten Leiterbahn 17 ein Kontakt mittels eines Bonddrahts 15 dargestellt. Der Bonddraht führt an ein Gehäusepin.

Zur Herstellung des in Figur 1 gezeigten Emulationschips wird der Serienproduktchip ohne Veränderung hergestellt bis zu seiner oberen Verdrahtungsschicht 6. Anstelle der ansonsten üblichen Passivierung werden in weiteren an sich bekannten Herstellungsschritten die Isolationsschicht 11, die weitere Verdrahtungsschicht 10 sowie Kontaktwarzen 14 bzw. Bonddrähte 15 aufgebracht. Dies erfordert etwa 3 bis 4 zusätzliche Maskenschritte gegenüber der Herstellung des Serienchips. Denkbar wäre auch die Herstellung dieser zusätzlichen Schichten mittels an sich bekannter Laserstrahlschreibtechniken, da die Emulationschips nur in geringen Stückzahlen zu fertigen sind und die Strukturgröße unkritisch ist.

In vorteilhafter Weiterbildung der Erfindung ist in Figur 2 ein weiterer Schaltkreis 20 dargestellt, der zur Ausgabe der an den Leiterbahnen 16, 17 anliegenden Signale dient. Der Ausgabechip 20 weist weitere für die In-Circuit-Emulation geeignete Schaltungen und Treiberstufen auf. Zur Herstellung der Emulationschipanordnung werden an den entsprechenden Kontaktstellen der Leiterbahnen 16, 17 Kontaktwarzen 21, 22 aufgebracht. Diese bestehen aus lötfähigem Material. Anschließend wird der Chip 20, der an dem jeweiligen Ort der Lötkugeln 21, 22 entsprechende Kontaktflächen aufweist, aufgelötet. Diese Bearbeitungsvorgänge sind an die Flip-Chip-Technik angelehnt, mit der integrierte Schaltkreise auf Leiterplatten kontaktiert und befestigt werden. Im vorliegenden Fall jedoch werden zwei integrierte Schaltkreise miteinander verbunden. Diejenigen Oberflächen, über die die Schaltungsstrukturen der Schaltkreise und die Anschlußflächen zugänglich sind, sind dabei einander zugewandt.

Alternativ zu der in Figur 2 dargestellten Orientierung des Ausgabechips 20 kann ein anderer Ausgabechip vorgesehen werden, der im Sinne einer vertikalen Integration über dem Emulationschip 3 angeordnet ist, wobei auf der Verdrahtungsschicht 10 unmittelbar das Substrat der zweiten integrierten Schaltung aufsetzt, in welches von der gegenüberliegenden, von der Verdrahtungsschicht 10 abweisenden Oberfläche her die Transistorstrukturen eingebracht sind. Vertikale Schächte im zweiten Chip werden auf die Verbindungsflächen 16, 17 geführt und sorgen für eine Verbindung dieser Flächen zu den Funktionseinheiten im zweiten Chip.

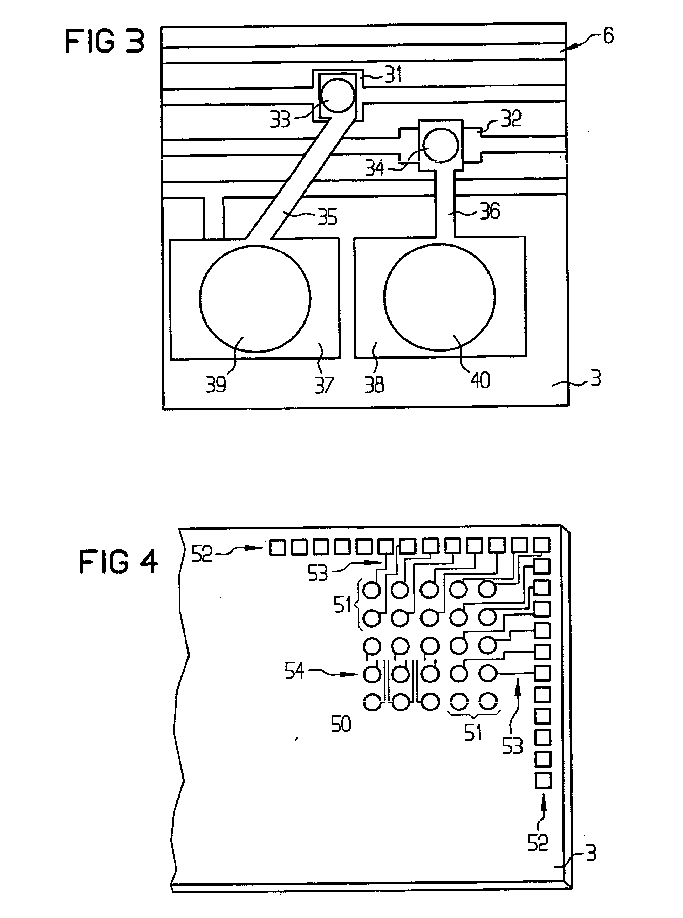

Die in Figur 3 dargestellte Aufsicht auf die Oberfläche des Emulationschips 3 zeigt die Leiterbahnen der obersten Verbindungsschicht 6 des Serienproduktchips. In dem in Figur 3 dargestellten Ausschnitt sind vier Busleitung abgebildet. Die Leitungen weisen Kontaktflächen 31, 32 auf, an denen jeweils ein Durchgangsloch und -kontakt 33, 34 zur zusätzlich im Emulationschip vorhandenen Verbindungsebene 10 angeordnet ist. Die Kontaktflächen 31, 32 sind entsprechend den Designregeln ausgeführte Verbreiterungen der Leitungen. Die zweckmäßigerweise aus Metall gebildeten Leitungen 35, 36 der Verbindungsschicht 10 verbinden die Kontaktflächen 31, 32 mit Anschlußpads 37, 38, an denen der Kontakt nach außen hergestellt wird mittels Bonddrähten oder Lötwarzen 39, 40. Die Anschlußpads 37, 38 liegen zweckmäßigerweise an solchen Orten, unter denen sich keine sensiblen Bauelemente befinden, die durch das Bonden oder Löten zerstört werden könnten. Der Durchmesser einer Leiterbahn der Ebene 6 liegt bei heutigen Technologien in der Größenordnung von 3 µm und darunter, die Ausdehnung einer Anschlußfläche 37 oder 38 in Schicht 10 liegt in einer Größenordnung von etwa 150 µm. Die in Figur 3 gezeigte Darstellung ist aus Gründen der Übersichtlichkeit daher nicht maßstabsgerecht.

Die in Figur 4 dargestellte Aufsicht auf den mit den gegenüber dem Produktchip zusätzlichen Herstellungsschritten weitergebildeten Emulationschip zeigt einen Ausschnitt 50 aus der Anordnung der Lötwarzen. Darüber hinaus sind die normalen, auch im Produktchip vorhandenen Ausgangspads vorgesehen, auf die die Bonddrähte zu den Gehäusepins aufgestempelt werden. Der Kontakt zum Ausgabechip erfolgt jedoch nur über die Kontaktwarzen 50. Daher sind auch die "normalen" Anschlußpads 52 an Lötwarzen 51 durch entsprechende Leitungen 53 in der Verdrahtungsschicht 10 geführt. Diese Lötwarzen liegen im äußeren Bereich, während die übrigen, flächeninneren Lötwarzen 54 an chipinterne Signalleitungen angeschlossen sind, die im Produktchip nicht direkt von außen zugänglich sind, wie beispielsweise chipinterne Busleitungen. Die Lötwarzen 50 sind in einem vorgegebenen Raster angeordnet. Im dargestellten Beispiel weisen die Lötwarzen untereinander in jede Richtung jeweils gleiche Abstände auf. Für horizontale und vertikale Richtungen können im allgemeinen die Abstände verschieden sein. Zweckmäßigerweise ist das Raster für verschiedene Typen von Produktchips gleich. Ebenso führen die in ihrer Lage sich jeweils entsprechenden Lötwarzen funktionsentsprechende Signale. Es ist dadurch möglich, daß der gleiche Ausgabechip für unterschiedliche Emulationschips und daher unterschiedliche Produktchipstypen verwendet wird. Dies ist kostengünstig und verringert den Zeitnachlauf zur Herstellung der Emulationschipanordnung.

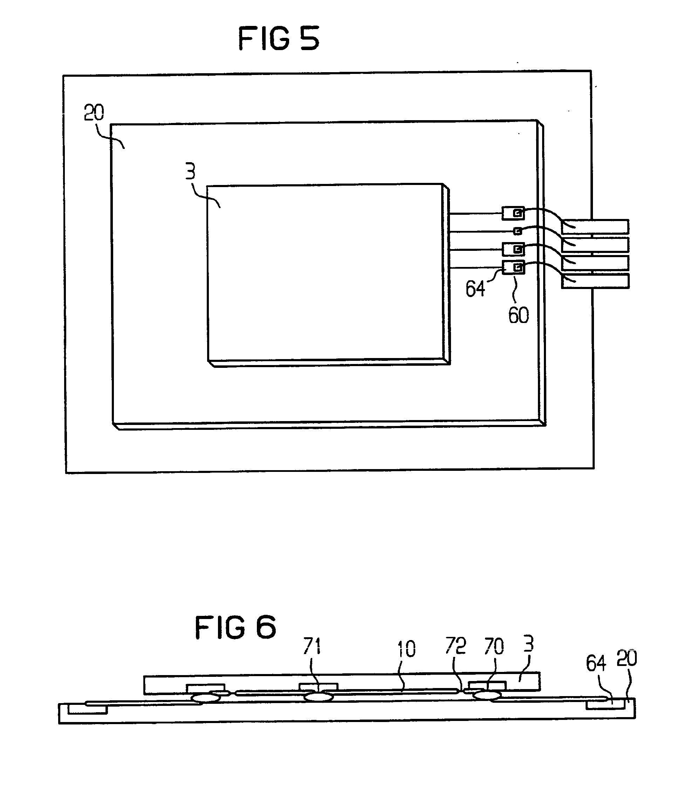

Figur 5 zeigt, daß der Ausgabechip 20 flächenmäßig größer als der Emulationschip 3 ist. Die in Figur 4 dargestellte Struktur ist in Figur 5 dem Ausgabechip 20 zugewandt. Im Emulationschip 3 sind für die In-Circuit-Emulation geeignete Schaltungen angeordnet. Dies sind beispielsweise Treiber, durch die die Ausgangssignale an Außenanschlußpads 60 bereitgestellt werden. Zweckmäßig sind auch ein Beobachtungskanalspeicher (sogenannter Trace Buffer), in dem ein zeitlicher Rückblick von für den Funktionstest der Schaltung ausgewählten Registern gespeichert wird, oder ein Programmemulationsspeichers, der das Arbeitsprogramm für den zu testenden Microcontroller enthält. Während des Normalbetriebs ist das Arbeitsprogramm in einem ROM-Speicher im Microcontroller abgelegt. Durch die enge räumliche Kopplung zwischen Programmemulationsspeicher und Emulationschip sind die entsprechenden Verbindungsleitungen kurz und der Emulationsspeicher kann bei der Systemfrequenz betrieben werden. Außerdem enthält der Ausgabechip 20 geeignete Logik für das Setzen und Überwachen von Programmunterbrechungspunkten. Die Pads 60 des Ausgabechips führen Signale, die mit den inneren Lötkugeln 54 des Emulationschips verbunden sind. Zweckmäßigerweise sind diesen Pads 60 Schutzstrukturen 64 gegen elektrostatische Entladungen (Electrostatic Discharge, ESD) zugeordnet, die bei einer elektrostatischen Überspannung den Ladungsimpuls zu einem Versorgungsspannungsanschluß abführen. Das Ausgangspad 63 ist beispielsweise mit einer der Lötkugeln 51 des Emulationschips 3 verbunden, die auch im Produktchip einen Ausgang darstellen. Es ist daher keine ESD-Schutzstruktur im Ausgabechip vorgesehen. Die Pads befinden sich auf einem Padring am Rand des Ausgabechips 20. Die gemeinsame Anordnung von Emulationschip 3 und Ausgabechip 20 ist wiederum in einem Gehäuse 65 mit Ausgabepins 66 eingeschlossen.

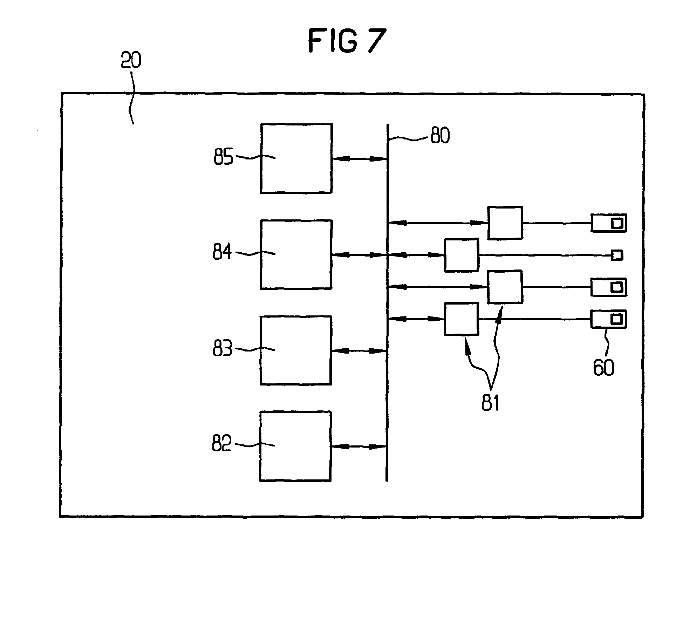

In Figur 7 ist ein Blockschaltbild des Ausgabechips 20 gezeigt. Der Ausgabechip enthält einen Bus 80, über den die interne Kommunikation läuft. Ausgangsseitig vor den Pads 60 ist in jede Ausgangsleitung ein Treiber 81 geschaltet, durch den die auszugebenden Signale verstärkt und von den internen Schaltungsblöcken entkoppelt werden. Die Funktionsblöcke 82, ..., 85 enthalten diejenigen Funktionseinheiten, die für die In-Circuit-Emulation und die Aufbereitung der auszugebenden und überwachenden Signale wie oben beschrieben erforderlich sind. Der Funktionsblock 82 enthält den Trace-Buffer-Speicher. Der Funktionsblock 83 enthält den Programmemulationsspeicher. Der Funktionsblock 84 enthält die Logik zum Setzen und Überwachen von Programmunterbrechungspunkten. Der Funktionsblock 85 bildet eine Schnittstelle zu den Signalen, die vom Emulationschip 3 abgegriffen werden. Er enthält entsprechende Puffer-Treiber.

Die Funktionseinheiten des Ausgabechips 20 können fest verdrahtet bereitgestellt werden. Der Emulationschip 3 ist dann stets auf die feste Schnittstelle im Ausgabechip 20 anzupassen. Vorteilhafterweise sind schnittstellenrelevante Funktionseinheiten programmierbar ausgeführt. Besonders eignet sich hierzu programmierbare Logik. Sie werden auf dem Ausgabechip zusammen mit den nicht schnittstellenrelevanten, in allen Anwendungsfällen gleich bleibenden Funktionseinheiten integriert. Über die programmierbare Logik werden die vom Emulationschip 3 aus- und eingegebenen Signale zu den übrigen Funktionseinheiten geführt. Solche programmierbaren Logikschaltungsblöcke sind beispielsweise als FPGA (Field Programmable Gate Array) verfügbar. Ein FPGA ist blockweise aufgebaut. Jeder Block enthält im wesentlichen Logikschaltungselemente und Speicherelemente und einstellbare Schalter. Die Schalterstellung wird so gewählt, daß sich die gewünschte Logikfunktion bei einem gewünschten Zeitverhalten ergibt. Der Einstellzustand der Schalter wird über den Inhalt eines flüchtigen Speichers festgelegt. Je nach Speicherinhalt können somit die Logikfunktionen der Schnittstelle an den gerade angeschlossenen Emulationsschaltkreis angepaßt werden. Im vorliegenden Ausführungsbeispiel werden vorzugsweise die Funktionsblöcke 84 und 85 im FPGA realisiert. Die Funktionalität der Schnittstelle zum Emulationschip kann sehr flexibel sowohl an den Emulationschip als auch an den Hersteller der übrigen Emulatorhardware angepaßt werden.

Anstelle einer programmierbaren Logikschaltung kann auch ein Gate Array vorgesehen werden. Dabei handelt es sich um eine regelmäßige Anordnung von vorgefertigen Transistoren, die in weiteren Herstellungsschritten dann mit Leiterbahnen in Metallebenen verbunden werden. Die Anpassung des Ausgabechips an die gewünschten Schnittstelleneigenschaften erfolgt hier während der Endschritte von dessen Herstellung durch das Aufbringen einer geeigneten Leiterbahn. Dies bedeutet, daß die Schnittstelle maskenprogrammierbar bezüglich der Herstellungsmasken für die Verdrahtung ist.

Figur 6 zeigt einen Querschnitt durch die Anordnung der Figur 5. Das Ausgangspad 64 ist über eine Lötkugel 70 mit dem Emulationschip 3 verbunden, die an eine interne Signalleitung angeschlossen ist. Solange die Verbindung zwischen Lötkugel 70 und Ausgangspad 64 während der Montage noch nicht hergestellt ist, ist die mit der Lötkugel 70 verbundene Leitung im Emulationschip ESD-gefährdet. Daher wird in der Verdrahtungsschicht 10 des Emulationschips 3 eine Leiterbahn zwischen Lötkugel 70 und einer für einen Anschluß für ein Versorgungspotential, vorzugsweise Masse, vorgesehenen Lötkugel 71 gebildet. Diese Leiterbahn weist eine Engstelle mit verringertem Querschnitt 72 auf. Diese ist so dimensioniert, daß sie einen ESD-Impuls zum Versorgungsanschluß 71 abführen kann, jedoch durch einen von außen eingeprägten Stromimpuls unterbrochen werden kann. Wenn nach erfolgter Montage der beiden Chips die Lötkugel 70 mit dem ESD-geschützten Pad 70 verbunden ist, wird die Engstelle 72 durch einen von außen eingeprägten Stromimpuls unterbrochen. Die oben beschriebene Masseverbindung zwischen den Lötkugeln 70, 71 ist anschließend nicht mehr wirksam.

## Patentansprüche

1. Anordnung mit zwei integrierten Schaltkreisen mit
- einem ersten integrierten Schaltkreis (3), der in der obersten Verdrahtungsschicht (6) Kontaktflächen (13, 31, 32) aufweist, wobei sich über der obersten Verdrahtungsschicht (6) eine weitere Verdrahtungsschicht (10) befindet, die mit den Kontaktflächen (13, 31, 32) verbundene Leiterbahnen (16, 17) aufweist, und
- einem zweiten integrierten Schaltkreis (20), der auf dem ersten integrierten Schaltkreis (3) angeordnet ist und Kontaktflächen aufweist, die mit entsprechenden Kontaktstellen der weiteren Verdrahtungsschicht (10) des ersten integrierten Schaltkreises (3) verbunden sind,
- wobei der zweite integrierte Schaltkreis (20) flächenmäßig größer als der erste integrierte Schaltkreis (3) ist und randseitig Anschlußflächen (60, 63) für eine Kontaktierung nach außerhalb aufweist,
- wobei der erste integrierte Schaltkreis (3) einen Mikroprozessor oder einen Mikrocontroller enthält, und
- wobei der zweite integrierte Schaltkreis (20) den Anschlußflächen für die Außenkontaktierung zugeordnete Treiberschaltungen (81) aufweist und einen für eine In-Circuit-Emulation geeigneten Beobachtungskanalspeicher (82), der mit Registern des Mikroprozessors bzw. des Mikrocontrollers verbunden ist, und/oder einen für eine In-Circuit-Emulation geeigneten Programmemulationsspeicher (83), und/oder Logikschaltungen für das Setzen und Überwachen von Unterbrechungspunkten des Emulationsprogramms (84) aufweist.

2. Anordnung nach Anspruch 1,
**dadurch gekennzeichnet, daß** die Verbindung zwischen den Kontaktflächen der integrierten Schaltkreise mittels Kontaktwarzen (21, 22, 39, 40) bewirkt ist.

3. Anordnung nach einem der Ansprüche 1 oder 2,
**dadurch gekennzeichnet, daß**
die Oberflächen der integrierten Schaltkreise (3, 20), an denen die jeweiligen Kontaktflächen zugänglich sind, einander zugewandt sind.

4. Anordnung nach einem der Ansprüche 1 bis 3,
**gekennzeichnet durch**
rastermäßige Anordnung (50) einer Anzahl der Kontaktflächen des ersten integrierten Schaltkreises (3), bei der in eine Richtung die Kontaktflächen jeweils gleiche Abstände aufweisen.

5. Anordnung nach Anspruch 1,
**dadurch gekennzeichnet, daß**
der zweite integrierte Schaltkreis (20) eine Schnittstelle zum ersten integrierten Schaltkreis (3) enthält, und daß die die Schnittstelle zum ersten integrierten Schaltkreis (3) bildenden Komponenten durch eine programmierbare logische Schaltung gebildet sind.

6. Anordnung nach den Ansprüche 10,
**dadurch gekennzeichnet, daß**
der zweite integrierte Schaltkreis (20) eine Schnittstelle zum ersten integrierten Schaltkreis (3) enthält, und daß die die Schnittstelle zum ersten integrierten Schaltkreis (3) bildenden Komponenten als ein maskenprogrammierbares Gate Array ausgeführt sind.

7. Anordnung nach den Ansprüchen 5 oder 6,
**dadurch gekennzeichnet, daß**
die genannten Schnittstellenkomponenten die Logikschaltungen für das Setzen und Überwachen von Unterbrechungspunkten des Emulationsprogramms (84) umfassen und/oder Pufferschaltungselemente zur Signalein- und ausgabe (85) bezüglich des ersten integrierten Schaltkreises (3).

8. Anordnung nach einem der vorhergehenden Ansprüche,
**dadurch gekennzeichnet, daß**
in der weiteren Verdrahtungsschicht (10) des ersten integrierten Schaltkreises (3) die Kontaktflächen mit einem Anschluß (71) für ein Versorgungspotential über Leiterbahnen verbunden sind, die einen Abschnitt (72) mit verringerter Querschnittsfläche aufweisen, so daß nach dem Verbinden der Kontaktflächen des zweiten integrierten Schaltkreises (20) mit den Kontaktflächen des ersten integrierten Schaltkreises (3) die Abschnitte (72) verringerter Querschnittsfläche durch einen über den zweiten integrierten Schaltkreis (20) eingeprägten Stromimpuls unterbrechbar sind.

## Claims

1. Arrangement with two integrated circuits having
- a first integrated circuit (3), which has contact areas (13, 31, 32) in the topmost wiring layer (6), wherein a further wiring layer (10) is located above the topmost wiring layer (6), said further wiring layer having interconnects (16, 17) which are connected to the contact areas (13, 31, 32), and
- a second integrated circuit (20), which is arranged on the first integrated circuit (3) and has contact areas, which are connected to corresponding contact points on the further wiring layer (10) of the first integrated circuit (3),
- wherein the second integrated circuit (20) is larger in terms of area than the first integrated circuit (3) and has pads (60, 63) at the edge for making contact on the outside,
- wherein the first integrated circuit (3) contains a microprocessor or a microcontroller, and
- wherein the second integrated circuit (20) has driver circuits (81) associated with the pads for making contact with the outside and has an observation channel memory (82), which is suitable for an in-circuit emulation and which is connected to registers of the microprocessor or the microcontroller, and/or has a program emulation memory (83) suitable for an in-circuit emulation, and/or has logic circuits for setting and monitoring interrupt points for the emulation program (84).

2. Arrangement according to Claim 1,
**characterized in that**
the connection between the contact areas of the integrated circuits is made using contact studs (21, 22, 39, 40).

3. Arrangement according to either of Claims 1 and 2,
**characterized in that**
the surfaces of the integrated circuits (3, 20) on which the respective contact areas are accessible face one another.

4. Arrangement according to one of Claims 1 to 3,
**characterized by**
a number of the contact areas of the first integrated circuit (3) being in a grid-like arrangement (50) in which the contact areas are spaced apart by the same amount in each case in one direction.

5. Arrangement according to Claim 1,
**characterized in that**
the second integrated circuit (20) contains an interface to the first integrated circuit (3), and **in that** the components which form the interface to the first integrated circuit (3) are formed by a programmable logic circuit.

6. Arrangement according to Claim 10,
**characterized in that**
the second integrated circuit (20) contains an interface to the first integrated circuit (3), and **in that** the components which form the interface to the first integrated circuit (3) are configured as a mask-programmable gate array.

7. Arrangement according to Claim 5 or 6,
**characterized in that**
the aforesaid interface components comprise the logic circuits for setting and monitoring interrupt points for the emulation program (84) and/or buffer-circuit elements for inputting and outputting (85) signals for the first integrated circuit (3).

8. Arrangement according to one of the preceding claims,
**characterized in that**
the contact areas in the further wiring layer (10) of the first integrated circuit (3) are connected via interconnects to a connection (71) for a supply potential, said interconnects having a section (72) with reduced cross-sectional area, with the result that, after the contact areas of the second integrated circuit (20) have been connected to the contact areas of the first integrated circuit (3), the sections (72) with reduced cross-sectional area can be interrupted by means of a current pulse impressed via the second integrated circuit (20).

## Revendications

1. Dispositif comportant deux circuits intégrés, comprenant
- un premier circuit intégré (3) qui présente des surfaces de contact (13, 31, 32) dans la couche de câblage supérieure (6), dans lequel une couche de câblage supplémentaire (10) qui comprend des pistes conductrices (16, 17) connectées aux surfaces de contact (13, 31, 32) se trouve sur la couche de câblage supérieure (6), et
- un second circuit intégré (20) qui est disposé sur le premier circuit intégré (3) et présente des surfaces de contact qui sont connectées à des points de contact correspondants de la couche de câblage supplémentaire (10) du premier circuit intégré (3),
- dans lequel le second circuit intégré (20) présente une superficie supérieure à celle du premier circuit intégré (3) et comprend des surfaces de raccordement de bord (60, 63) pour une mise en contact vers l'extérieur,
- dans lequel le premier circuit intégré (3) contient un microprocesseur ou un microcontrôleur, et
- dans lequel le second circuit intégré (20) présente des circuits d'attaque (81) associés aux surfaces de raccordement pour la mise en contact extérieure et présente une mémoire de canal d'observation (82) appropriée pour une émulation intégrée au circuit qui est connectée à des registres du microprocesseur ou du microcontrôleur, et/ou une mémoire d'émulation de programme (83) appropriée pour une émulation intégrée au circuit, et/ou des circuits logiques destinés à régler ou surveiller des points d'interruption du programme d'émulation (84).

2. Dispositif selon la revendication 1, **caractérisé en ce que** la connexion entre les surfaces de contact des circuits intégrés est assurée au moyen de bosses de contact (21, 22, 39, 40).

3. Dispositif selon l'une des revendications 1 ou 2, **caractérisé en ce que** les surfaces des circuits intégrés (3, 20) sur lesquelles les surfaces de contact respectives sont accessibles, sont situées à l'opposé l'une de l'autre.

4. Dispositif selon l'une quelconque des revendications 1 à 3, **caractérisé par** un agencement tramé (50) d'un certain nombre des surfaces de contact du premier circuit intégré (3) selon lequel les surfaces de contact présentent respectivement des distances égales dans une direction.

5. Dispositif selon la revendication 1, **caractérisé en ce que** le second circuit intégré (20) contient une interface avec le premier circuit intégré (3) et **en ce que** les composants constituant l'interface avec le premier circuit intégré (3) sont formés par un circuit logique programmable.

6. Dispositif selon la revendication 10, **caractérisé en ce que** le second circuit intégré (20) contient une interface avec le premier circuit intégré (3) et **en ce que** les composants formant l'interface avec le premier circuit intégré (3) sont réalisés sous la forme d'un réseau prédiffusé de portes programmables par masque.

7. Dispositif selon la revendication 5 ou 6, **caractérisé en ce que** lesdits composants d'interface comprennent des circuits logiques destinés à régler et surveiller des points d'interruption du programme d'émulation (84) et/ou des éléments de circuit tampon destinés à la fourniture en entrée et en sortie de signaux (85) en rapport avec le premier circuit intégré (3).

8. Dispositif selon l'une quelconque des revendications précédentes, **caractérisé en ce que**, dans la couche de câblage supplémentaire (10) du premier circuit intégré (3), les surfaces de contact sont connectées par l'intermédiaire de pistes conductrices à un raccordement (71) destiné à un potentiel d'alimentation, lesquelles pistes comportent une partie (72) de section transversale réduite, de manière à ce que, après la connexion des surfaces de contact du second circuit intégré (20) aux surfaces de contact du premier circuit intégré (3), les parties (72) de section transversale réduite puissent être déconnectées par une impulsion de courant appliquée par l'intermédiaire du second circuit intégré (20).
